# EUROPÄISCHE PATENTSCHRIFT

(11) **EP 1 672 798 B1**
(45) Veröffentlichungstag und Bekanntmachung des Hinweises auf die Patenterteilung: **14.04.2010**
(21) Anmeldenummer: 05026785.5
(22) Anmeldetag: 08.12.2005
(51) Int. Cl.: H03K 17/96

(54) **Schaltungsanordnung für einen kapazitiven Berührungsschalter**
Electronic circuit for a capacitive touch switch
Circuit électronique pour un commutateur capacitif à effleurement

(30) Priorität: 17.12.2004 DE 102004060847; 01.04.2005 DE 102005014933
(43) Veröffentlichungstag der Anmeldung: 21.06.2006
(73) Patentinhaber: Diehl AKO Stiftung & Co. KG, 88239 Wangen (DE)
(72) Erfinder: Müller, Roland, 88145 Opfenbach (DE); Mangold, Harald, 73463 Lippach (DE); Kaps, Werner, 88171 Weiler-Simmerberg (DE)
(74) Vertreter: Diehl Patentabteilung

(56) Entgegenhaltungen:
- EP-A- 0 632 593
- EP-B1- 0 632 593
- DE-U1- 29 721 213
- US-A- 4 939 382
- US-A- 5 189 417

## Beschreibung

Die vorliegende Erfindung betrifft eine Schaltungsanordnung für mehrere kapazitive Berührungsschalter.

In vielen elektrischen Geräten, insbesondere auch in Haushaltsgeräten wie Herden, Kochfeldern, Mikrowellenöfen, Spülmaschinen, Waschmaschinen und dergleichen, werden immer häufiger Berührungsschalter eingesetzt, die durch ein einfaches Berühren durch einen Benutzer einen bestimmten Schaltvorgang auslösen. Im Fall eines kapazitiven Berührungssensors bzw. -schalters weist die Sensorschaltung zum Beispiel ein Kondensator-Flächenelement auf, das zusammen mit dem Benutzer eine Kapazität bildet, die entsprechend dem Betätigen des kapazitiven Sensorelements, d.h. dem Berühren oder Nicht-Berühren des Kondensator-Flächenelements variabel ist. Die Veränderung der Kapazität des kapazitiven Sensorelements durch eine Berührung durch den Benutzer wirkt sich entsprechend auf ein Ausgangssignal der Sensorschaltung aus, was von einer angeschlossenen Auswerteschaltung entsprechend als eine Betätigung des kapazitiven Berührungsschalters ausgewertet wird.

Eine derartige Schaltungsanordnung für einen kapazitiven Berührungsschalter ist zum Beispiel aus den Dokumenten DE 32 45 803 A1, DE 103 03 480 A1 oder EP 0 859 468 B1 bekannt.

Ferner offenbart die EP 0 632 593 A1 eine Schaltungsanordnung für einen kapazitiven Berührungsschalter, die eine Sensorschaltung mit einem kapazitiven Sensorelement und eine mit dieser verbundene Auswerteschaltung aufweist, wobei die Sensorschaltung eine Kapazität, die parallel zum kapazitiven Sensorelement geschaltet ist, und einen Kapazitäts/Frequenz-Umsetzer, der mit der Parallelschaltung aus Kapazität und kapazitivem Sensorelement verbunden ist und der an seinem Ausgang ein Frequenzsignal erzeugt, dessen Frequenz von der Gesamtkapazität der Parallelschaltung aus Kapazität und kapazitivem Sensorelement abhängt, aufweist.

Der vorliegenden Erfindung liegt die Aufgabe zugrunde, eine Schaltungsanordnung für mehrere kapazitive Berührungsschalter zu schaffen, die eine einfache Auswertung der Ausgangssignale der Sensorschaltungen ermöglicht.

Diese Aufgabe wird durch eine Schaltungsanordnung mit den Merkmalen des Anspruchs 1 gelöst. Vorteilhafte Ausgestaltungen und Weiterbildungen der Erfindung sind Gegenstand der abhängigen Ansprüche.

Die Schaltungsanordnung für mehrere kapazitive Berührungsschalter enthält mehrere Sensorschaltungen mit jeweils einem kapazitiven Sensorelement, das bei Berührung seinen Kapazitätswert verändert, und eine Auswerteschaltung, der die Ausgangssignale der mehreren Sensorschaltungen über einen Schalter im Wechsel zugeführt werden, um zu bestimmen, ob die kapazitiven Sensorelemente betätigt werden oder nicht. Jede der mehreren Sensorschaltungen weist eine Parallelschaltung aus einer Kapazität und dem kapazitiven Sensorelement auf, wobei mit der Parallelschaltung jeweils ein Kapazitäts/Frequenz-Umsetzer verbunden ist, der an seinem Ausgang ein Frequenzsignal erzeugt, dessen Frequenz von der Gesamtkapazität der jeweiligen Parallelschaltung der Kapazität und des kapazitiven Sensorelements abhängt. Ferner weist jede der mehreren Sensorschaltungen einen abschaltbaren Rechteckoszillator auf, der aus dem Kapazitäts/Frequenz-Umsetzer und der Kapazität aufgebaut ist, wobei zeitgleich lediglich einer der mehreren Rechteckoszillatoren aktiviert ist.

Die Gesamtkapazität am Eingang des Kapazitäts/Frequenz-Umsetzers wird einerseits durch die feste Kapazität und andererseits durch den Kapazitätswert des kapazitiven Sensorelements der jeweils über den Schalter ausgewählten Sensorschaltung bestimmt. Die Veränderung des Kapazitätswerts des jeweiligen kapazitiven Sensorelements bei Berührung führt zu einer entsprechenden Veränderung der Gesamtkapazität der jeweiligen Sensorschaltung, was wiederum zu einer Veränderung der Frequenz des Ausgangssignals des Kapazitäts/Frequenz-Umsetzers führt. Da zeitgleich lediglich einer der mehreren abschaltbaren Rechteckoszillatoren aktiviert ist, was eine wechselseitige negative Beeinflussung der Sensorschaltungssignale ausschließt, muss die Auswerteschaltung zur Bestimmung, ob die kapazitiven Berührungsschalter betätigt werden, nur eine Frequenzänderung des Ausgangssignals des Kapazitäts/Frequenz-Umsetzers auswerten, was mit einfachen Mitteln möglich ist.

Der Eingang des Kapazitäts/Frequenz-Umsetzers ist bevorzugt parallel zur Parallelschaltung der Kapazität und des kapazitiven Sensorelements geschaltet.

In einer Ausführungsform der Erfindung ist der Kapazitäts/Frequenz-Umsetzer jeweils aus einem negierenden UND-Glied (NAND) mit Eingangshysterese gebildet. Durch den zweiten Eingang des negierenden UND-Gliedes ist es so möglich, den so gebildeten Rechteckoszillator, dessen Oszillationsfrequenz von der Gesamtkapazität der Schaltungsanordnung abhängt, abzuschalten bzw. in einen statischen Zustand zu bringen.

Ferner enthält die Auswerteschaltung zum Beispiel einen Ereigniszähler zum Zählen der Impulse des Ausgangssignals der mehreren Sensorschaltungen.

Außerdem ist es von Vorteil, wenn die Auswerteschaltung die Frequenz eines Ausgangssignals der mehreren Sensorschaltungen mit einer jeweiligen Basisfrequenz vergleicht, wobei die jeweilige Basisfrequenz eine über einen großen Zeitraum gemittelte Frequenz des Ausgangssignals der jeweiligen Sensorschaltung ohne Berührung des jeweiligen kapazitiven Sensorelements ist, um eine Drift der Schaltschwellen und der Bauteilwerte der Schaltungsanordnung auszugleichen.

Obige sowie weitere Merkmale und Vorteile der Erfindung werden aus der nachfolgenden Beschreibung bevorzugter, nicht-einschränkender Ausführungsbeispiele unter Bezugnahme auf die beiliegenden Zeichnungen besser verständlich. Darin zeigen:
- Fig. 1: ein Blockschaltbild zur Erläuterung des Grundprinzips der Schaltungs- anordnung gemäß der vorliegenden Erfindung;
- Fig. 2: ein Blockschaltbild einer Schaltungsanordnung für einen kapazitiven Berührungsschalter gemäß einem ersten Beispiel;
- Fig. 3: ein Blockschaltbild einer Schaltungsanordnung für mehrere kapazitive Berührungsschalter gemäß einem zweiten Beispiel;
- Fig. 4: ein Blockschaltbild einer Schaltungsanordnung für mehrere kapazitive Berührungsschalter gemäß einem dritten Beispiel;
- Fig. 5: ein Blockschaltbild einer Schaltungsanordnung für einen kapazitiven Berührungsschalter gemäß einem vierten Beispiel; und
- Fig. 6: ein Blockschaltbild einer Schaltungsanordnung für mehrere kapazitive Berührungsschalter gemäß einem ersten Ausführungsbeispiel der vor- liegenden Erfindung.

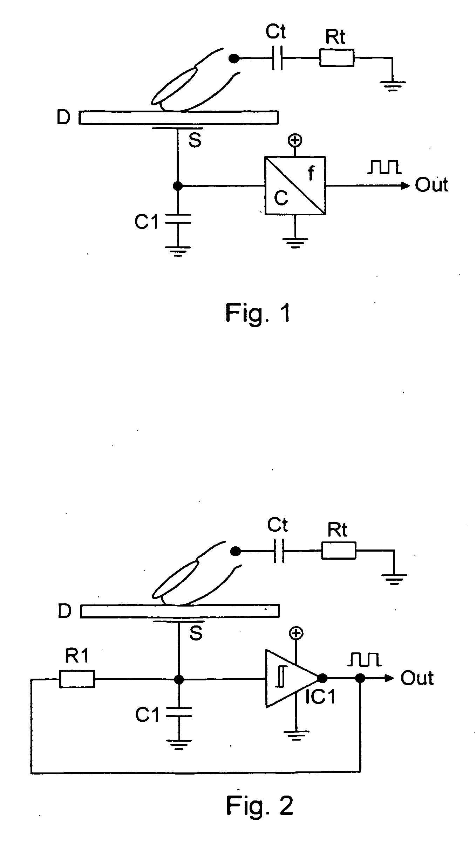

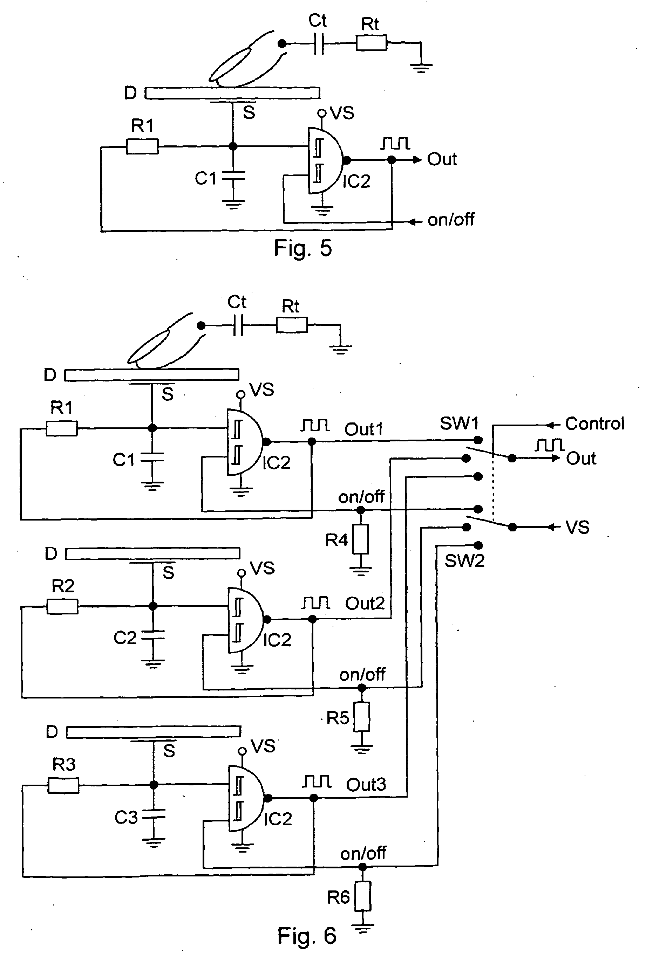

Fig. 1 zeigt den Grundaufbau einer Schaltungsanordnung für einen kapazitiven Berührungsschalter, der in elektrischen Geräten, insbesondere in elektrischen Haushaltsgeräten wie Herden, Kochfeldern, Mikrowellenöfen, Spülmaschinen, Waschmaschinen und dergleichen, einsetzbar ist. Anhand von Fig. 1 soll zunächst das Grundprinzip der vorliegenden Erfindung erläutert werden; anschließend werden unter Bezugnahme auf Fig. 2 bis 5 verschiedene Vergleichsbeispiele sowie unter Bezug auf Fig. 6 ein Ausführungsbeispiel einer erfindungsgemäßen Schaltungsanordnung beschrieben.

Die Schaltungsanordnung für einen kapazitiven Berührungsschalter umfasst eine Sensorschaltung und eine Auswerteschaltung, wobei in den Figuren jeweils nur die Sensorschaltung dargestellt ist, deren Ausgangssignal der Auswerteschaltung zugeführt wird. Die Sensorschaltung enthält insbesondere ein kapazitives Sensorelement S, zum Beispiel in Form eines Kondensator-Flächenelements, das zusammen mit einem Benutzer über ein Dieleketrikum D als Teil einer Bedientafel des Haushaltsgeräts eine Kapazität Ct bildet. Diese Kapazität Ct des Sensorelements S ist entsprechend dem Betätigen des kapazitiven Berührungsschalters, d.h. dem Berühren oder Nicht-Berühren des kapazitiven Sensorelements S, variabel. Es sei an dieser Stelle aber ausdrücklich darauf hingewiesen, dass die vorliegende Erfindung nicht auf eine spezielle Art oder Anordnung des kapazitiven Sensorelements S beschränkt ist.

Parallel zu diesem kapazitiven Sensorelement S ist eine Kapazität C1 geschaltet. Parallel zu der so gebildeten Parallelschaltung aus Kapazität C1 und kapazitivem Sensorelement S ist der Eingang eines Kapazitäts/Frequenz-Umsetzers Cf geschaltet. Dieser Kapazitäts/Frequenz-Umsetzer Cf erzeugt am Ausgang ein rechteckförmiges Frequenzsignal Out, dessen Frequenz von der Kapazität am Eingang des Kapazitäts/Frequenz-Umsetzers Cf abhängt.

Falls der kapazitive Berührungsschalter nicht betätigt wird, d.h. das kapazitive Sensorelement S nicht berührt wird, ist keine Kapazität Ct des Sensorelements vorhanden (Ct=0) und die Gesamtkapazität am Eingang des Kapazitäts/Frequenz-Umsetzers Cf wird allein durch die Kapazität C1 gebildet. In diesem Fall besitzt das Ausgangssignal Out des Kapazitäts/Frequenz-Umsetzers eine bestimmte Basisfrequenz. Wird dagegen der kapazitive Berührungsschalter betätigt, d.h. das kapazitive Sensorelement S berührt, wird die Gesamtkapazität am Eingang des Kapazitäts/Frequenz-Umsetzers Cf durch die Parallelschaltung der Kapazität C1 und des Kapazitätswerts Ct des kapazitiven Sensorelements S gebildet. Hierdurch verändert sich die Frequenz des Ausgangssignals Out des Kapazitäts/Frequenz-Umsetzers Cf.

Die Auswerteschaltung, der das Ausgangssignal Out des Kapazitäts/Frequenz-Umsetzers Cf zugeführt wird, kann durch Messen der Frequenz bzw. Auszählen der Impulse des Ausgangssignals Out der oben beschriebenen Sensorschaltung ein Berühren des kapazitiven Sensorelements S detektieren. Das Auszählen der Impulse erfolgt zum Beispiel mittels eines in einem Mikrocontroller integrierten Ereigniszählers.

Um eine in der Praxis entstehende Drift der Schaltschwellen und der Bauteilwerte der Sensorschaltung zu kompensieren, wird als Basisfrequenz von der Auswerteschaltung vorzugsweise die über einen relativ großen Zeitraum gemittelte Frequenz bei Nicht-Berührung des kapazitiven Sensorelements S herangezogen. Eine Betätigung des kapazitiven Berührungsschalters kann dementsprechend einfach durch einen Frequenzsprung des Ausgangssignals Out relativ zu dieser Basisfrequenz detektiert werden. Die Empfindlichkeit des kapazitiven Berührungsschalters kann durch die Höhe des Schwellenwerts für die Frequenzänderung in Bezug auf die Basisfrequenz eingestellt werden.

Anhand von Fig. 2 wird nun ein erstes Beispiel einer Schaltungsanordnung näher beschrieben.

Der Kapazitäts/Frequenz-Umsetzer Cf der Grundschaltungsanordnung von Fig. 1 ist durch einen Inverter IC1, der über einen Widerstand zurückgekoppelt ist und eine Eingangshysterese aufweist, gebildet. Unter Einbeziehung der Kapazität C1 bildet diese Anordnung einen Rechteckoszillator. Bestimmend für die Frequenz des Ausgangssignals Out des so gebildeten Rechteckoszillators sind neben den Höhen der Eingangs-Ein- und Ausschaltschwellen insbesondere der Widerstand R1, die Kapazität C1 und der über das kapazitive Sensorelement S eingebrachte Kapazitätswert Ct.

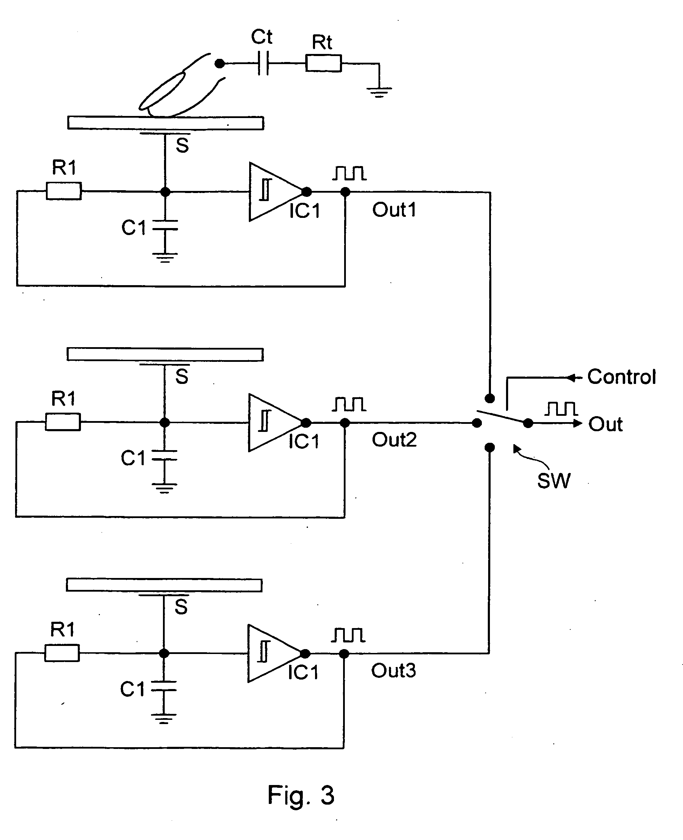

Wie in dem zweiten Beispiel von Fig. 3 veranschaulicht, kann diese Schaltungsanordnung für einen kapazitiven Berührungsschalter auch mehrere Sensorschaltungen aufweisen, deren Ausgangssignale Out1, Out2, Out3 einer gemeinsamen Auswerteschaltung (nicht dargestellt) zugeleitet werden.

Die einzelnen Sensorschaltungen entsprechen in ihrem Aufbau und ihrer Funktionsweise der oben anhand von Fig. 2 erläuterten Sensorschaltung; insbesondere enthält jede der Sensorschaltungen ein kapazitives Sensorelement S, eine Kapazität C1 und einen Kapazitäts/Frequenz-Umsetzer Cf. Die Ausgangssignale Out1, Out2, Out3 der (in diesem Fall drei) Sensorschaltungen werden den (in diesem Fall drei) Eingängen eines Wechselschalters SW zugeführt. Dieser Wechselschalter schaltet durch eine Steuerung der Auswerteschaltung seine Eingänge zeitlich nacheinander auf seinen einen Ausgang, sodass der Ausgangsschaltung zeitlich nacheinander die einzelnen Ausgangssignale Out1, Out2, Out3 zur weiteren Auswertung zugeführt werden.

Der Wechselschalter SW kann zum Beispiel durch einen Digital-Multiplexer-Baustein gebildet sein, der die Ausgangssignale Out1, Out2, Out3 der mehreren Sensorschaltungen im Zeitmultiplex-Verfahren auf den Ausgang setzt. Für die Auswertung von beispielsweise sechs kapazitiven Sensorelementen S sind nur ein Multiplexer-Baustein, ein Sechsfach-Inverter-Baustein mit Eingangshysterese sowie sechs Kondensatoren und Widerstände erforderlich.

Es ist selbstverständlich, dass die in Fig. 3 dargestellte Schaltungsanordnung nicht nur auf die drei Sensorschaltungen mit insgesamt drei kapazitiven Sensorelementen S beschränkt ist. Stattdessen können der gemeinsamen Auswerteschaltung auch die Ausgangssignale Out von nur zwei oder von mehr als drei Sensorschaltungen über den Wechselschalter SW zugeführt werden.

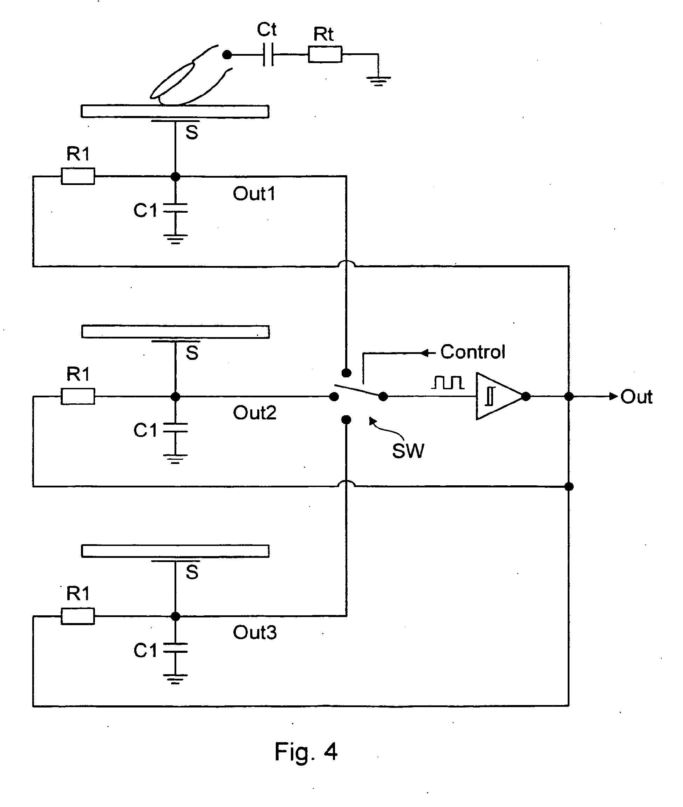

Fig. 4 zeigt als drittes Beispiel eine Variante des zweiten Beispiels einer Schaltungsanordnung mit mehreren Sensorschaltungen.

Die Schaltungsanordnung von Fig. 4 unterscheidet sich dadurch, dass hier die Parallelschaltung aus Kapazität C1 und Kapazitätswert Ct des kapazitiven Sensorelements S der mehreren Sensorschaltungen direkt mit den Eingängen des Wechselschalters SW verbunden sind. Der eine Ausgang des Wechselschalters SW ist in diesem Fall über einen Inverter IC1 mit der Auswerteschaltung verbunden. Der Ausgang des gemeinsamen Inverters IC1 ist jeweils über den Widerstand R1 in die einzelnen Sensorschaltungen zurückgekoppelt.

Diese Schaltungsanordnung ermöglicht für den Fall mehrerer Sensorschaltungen eine weitere Reduzierung der benötigten Bauteile, da nur ein einzelner Inverter IC1 für alle Sensorschaltungen eingesetzt werden muss.

Nachfolgend werden anhand der Fig. 5 und 6 ein viertes Beispiel bzw. ein erstes Ausführungsbeispiel erläutert.

Das vierte Beispiel und das erste Ausführungsbeispiel unterscheiden sich von dem oben beschriebenen ersten bzw. zweiten Beispiel darin, dass der Kapazitäts/Frequenz-Umsetzer Cf der Sensorschaltungen statt eines Inverters mit Eingangshysterese IC1 ein negierendes UND-Glied (NAND) mit Eingangshysterese IC2 aufweist. Weitere Komponenten der Schaltungsanordnungen und deren Funktionsweisen sind gleich den oben beschriebenen, sodass auf eine wiederholte Erläuterung davon im Detail verzichtet wird.

Wie in Fig. 5 dargestellt, ist ein Eingang des negierenden UND-Gliedes IC2, der eine Eingangshysterese aufweist, parallel zur Parallelschaltung der festen Kapazität C1 und des kapazitiven Sensorelements S geschaltet. Durch den anderen Eingang des negierenden UND-Gliedes lC2, bei dem keine Eingangshysterese erforderlich ist, ist es daher möglich, den durch das negierende UND-Glied aufgebauten Rechteckoszillator bei Bedarf abzuschalten bzw. in einen statischen Zustand zu bringen.

Dieses bedarfsweise Abschalten des Rechteckoszillators hat insbesondere bei mehreren vorhandenen Sensorschaltungen, die im Zeitmultiplexverfahren betrieben werden, den Vorteil, dass es möglich ist, nur jeweils den Rechteckoszillator in einen Schwingzustand zu versetzen, der gerade ausgewertet werden soll; alle übrigen Rechteckoszillatoren können abgeschaltet werden. Hierdurch kann insbesondere bei dicht zusammen liegenden Sensorleitungen (Verbindungsleitungen zwischen den Sensorelementen S und den Eingängen der Kapazitäts/Frequenz-Umsetzer Cf) eine Signal-Überkopplung vermieden werden, die aufgrund der hohen Empfindlichkeit der Eingänge der Kapazitäts/Frequenz-Umsetzer Cf sonst leicht möglich wäre.

Der Schaltungsaufbau eines solchen Ausführungsbeispiels mit mehreren Sensorschaltungen, deren Kapazitäts/Frequenz-Umsetzer Cf jeweils das negierende UND-Glied mit Eingangshysterese lC2 enthalten, ist in Fig. 6 veranschaulicht.

Die einzelnen Sensorschaltungen der Schaltungsanordnung von Fig. 6 entsprechen in ihrem Aufbau und ihrer Funktionsweise der oben anhand von Fig. 5 erläuterten Sensorschaltung; insbesondere enthält jede der Sensorschaltungen ein kapazitives Sensorelement S, eine Kapazität C1 und einen Kapazitäts/Frequenz-Umsetzer Cf mit einem negierenden UND-Glied lC2 mit Eingangshysterese. Die Ausgangssignale Out1, Out2, Out3 der (in diesem Fall drei) Sensorschaltungen werden den (in diesem Fall drei) Eingängen eines ersten Wechselschalters SW1 zugeführt. Dieser erste Wechselschalter SW1 schaltet durch eine Steuerung der Auswerteschaltung seine Eingänge zeitlich nacheinander auf seinen einen Ausgang, sodass der Ausgangsschaltung zeitlich nacheinander die einzelnen Ausgangssignale Out1, Out2, Out3 zur weiteren Auswertung zugeführt werden.

Im Zeitmultiplexverfahren kann jeweils für den Zeitraum, in dem die Frequenz der betreffenden Sensorschaltung ausgewertet werden soll, der zugehörige Rechteckoszillator eingeschaltet werden, während die Rechteckoszillatoren der übrigen Sensorschaltungen abgeschaltet bleiben, um eine evt. Signalüberkopplung zu verhindern. Das zeitgerechte Einschalten der Rechteckoszillatoren kann beispielsweise über einen weiteren Wechselschalter SW2, zum Beispiel in Form eines Demultiplexers, erfolgen, der synchron zum ersten Wechselschalter SW1 angesteuert wird. Damit ist es möglich, für den ersten und den zweiten Wechselschalter SW1 und SW2 die gleichen Steuersignale (Control) zu verwenden, was den Vorteil mit sich bringt, dass keine weiteren Steuerleitungen notwendig sind.

Im Unterschied zum ersten Wechselschalter SW1 für das Ausgangssignal Out ist beim zweiten Wechselschalter SW2 für das Einschalten der Rechteckoszillatoren jedoch die Signalrichtung umgekehrt, d.h. ein Eingang (VS) muss auf mehrere Ausgänge geführt werden. Dem Eingang des zweiten Wechselschalters SW2 kann ein festes EIN-Signal, zum Beispiel als Betriebsspannung Vs, als logische Eins oder als High zugeführt werden. Alternativ kann dem Eingang des zweiten Wechselschalters SW2 auch ein variables (gesteuertes) EIN-Signal zugeführt werden, sodass bei Bedarf auch alle Rechteckoszillatoren der Sensorschaltungen abgeschaltet werden können.

Das EIN-Signal wird durch den zweiten Wechselschalter SW2 auf die verschiedenen Rechteckoszillatoren der Sensorschaltungen verteilt. Falls die Ausgänge bei nichtdurchgeschaltetem EIN-Signal undefiniert (zum Beispiel hochohmig) sind, werden die Ausgänge des zweiten Wechselschalters SW2 jeweils mit einem Pull Down - Widerstand R4-R6 verbunden, um den auszuschaltenden Rechteckoszillatoren ein AUS-Signal, zum Beispiel als Masse, als logische Null oder als Low zuzuführen.

Es ist selbstverständlich, dass auch die in Fig. 6 dargestellte Schaltungsanordnung nicht nur auf die drei Sensorschaltungen mit insgesamt drei kapazitiven Sensorelementen S beschränkt ist. Stattdessen können der gemeinsamen Auswerteschaltung auch die Ausgangssignale Out von nur zwei oder von mehr als drei Sensorschaltungen über den ersten Wechselschalter SW1 zugeführt werden.

Auch wenn nicht ausdrücklich dargestellt, ist es als ein weiteres Beispiel auch möglich, auf der Basis der Schaltungsanordnung mit einer Sensorschaltung von Fig. 5 eine Schaltungsanordnung mit mehreren Sensorschaltungen analog Fig. 4 aufzubauen. Das heißt, die Parallelschaltungen aus fester Kapazität C1 und Kapazitätswert Ct des kapazitiven Sensorelements S der mehreren Sensorschaltungen werden direkt mit den Eingängen des ersten Wechselschalters SW1 verbunden, dessen Ausgang über ein negierendes UND-Glied mit Eingangshysterese IC2 mit der Auswerteschaltung verbunden ist.

Die oben in Zusammenhang mit Fig. 1 gemachten Ausführungen zu der Auswerteschaltung gelten selbstverständlich gleichermaßen für alle Beispiele und das eine Ausführungsbeispiel.

## Patentansprüche

1. Schaltungsanordnung für mehrere kapazitive Berührungsschalter, mit mehreren Sensorschaltungen mit jeweils einem kapazitiven Sensorelement (S), das bei Berührung seinen Kapazitätswert (Ct) verändert; und
einer Auswerteschaltung, der die Ausgangssignale (Out1, Out2, Out3) der mehreren Sensorschaltungen über einen Schalter (SW1) im Wechsel zugeführt werden, zum Bestimmen, ob die kapazitiven Sensorelemente (S) betätigt werden oder nicht, wobei
jede der mehreren Sensorschaltungen eine Parallelschaltung aus einer Kapazität (C1) und dem kapazitiven Sensorelement (S) aufweist, und mit der Parallelschaltung jeweils ein Kapazitäts/Frequenz-Umsetzer (Cf) verbunden ist, der an seinem Ausgang ein Frequenzsignal erzeugt, dessen Frequenz von der Gesamtkapazität der jeweiligen Parallelschaltung der Kapazität (C1) und des kapazitiven Sensorelements (S) abhängt, **dadurch gekennzeichnet, dass**
jede der mehreren Sensorschaltungen einen abschaltbaren Rechteckoszillator aufweist, der aus dem Kapazitäts/Frequenz-Umsetzer (Cf) und der Kapazität (C1) aufgebaut ist, und zeitgleich lediglich einer der mehreren Rechteckoszillatoren aktiviert ist.

2. Schaltungsanordnung nach Anspruch 1,
**dadurch gekennzeichnet,**
**dass** der Eingang des Kapazitäts/Frequenz-Umsetzers (Cf) jeweils parallel zur Parallelschaltung der Kapazität (C1) und des kapazitiven Sensorelements (S) geschaltet ist.

3. Schaltungsanordnung nach Anspruch 1 oder 2,
**dadurch gekennzeichnet,**
**dass** der Kapazitäts/Frequenz-Umsetzer (Cf) jeweils aus einem negierenden UND-Glied (IC2) gebildet ist, dessen mit der Parallelschaltung der Kapazität (C1) und des kapazitiven Sensorelements (S) verbundener Eingang eine Hysterese aufweist.

4. Schaltungsanordnung nach Anspruch 1,
**dadurch gekennzeichnet,**
**dass** der Kapazitäts/Frequenz-Umsetzer (Cf) jeweils ein negierendes UND-Glied mit Eingangshysterese (IC2) aufweist, dessen Ausgangssignal (Out1, Out2, Out3) dem Schalter (SW1) zugeführt wird.

5. Schaltungsanordnung nach einem der vorhergehenden Ansprüche,
**dadurch gekennzeichnet,**
**dass** die Auswerteschaltung einen Ereigniszähler zum Zählen der Impulse eines Ausgangssignals (Out1. Out2, Out3) der Sensorschaltungen enthält.

6. Schaltungsanordnung nach einem der vorhergehenden Ansprüche,
**dadurch gekennzeichnet,**
**dass** die Auswerteschaltung die Frequenz eines Ausgangssignals (Out1, Out2, Out3) der Sensorschaltungen mit einer jeweiligen Basisfrequenz vergleicht, wobei die jeweilige Basisfrequenz eine über einen großen Zeitraum gemittelte Frequenz des Ausgangssignals (Out1, Out2, Out3) der jeweiligen Sensorschaltung ohne Berührung des jeweiligen kapazitiven Sensorelements (S) ist.

## Claims

1. Circuit arrangement for a plurality of capacitive touch switches, said circuit arrangement having a plurality of sensor circuits each with a capacitive sensor element (S) which changes its capacitance value (Ct) when touched; and
an evaluation circuit which is alternately supplied with the output signals (Out, Out1, Out2, Out3) from the plurality of sensor circuits via a switch (SW1) in order to determine whether the capacitive sensor elements (S) are actuated or not,
each of the plurality of sensor circuits having a parallel circuit comprising a capacitance (C1) and the capacitive sensor element (S), and a respective capacitance/frequency converter (Cf) which generates, at its output, a frequency signal whose frequency depends on the total capacitance of the respective parallel circuit comprising the capacitance (C1) and the capacitive sensor element (S) being connected to the parallel circuit, **characterized in that**
each of the plurality of sensor circuits has a square-wave oscillator which can be switched off and is constructed from the capacitance/frequency converter (Cf) and the capacitance (C1), and only one of the plurality of square-wave oscillators is activated at the same time.

2. Circuit arrangement according to Claim 1, **characterized in that**
the input of the capacitance/frequency converter (Cf) is connected in each case in parallel with the parallel circuit comprising the capacitance (C1) and the capacitive sensor element (S).

3. Circuit arrangement according to Claim 1 or 2, **characterized in that**
the capacitance/frequency converter (Cf) is in each case formed from a negating AND gate (IC2) whose input which is connected to the parallel circuit comprising the capacitance (C1) and the capacitive sensor element (S) has hysteresis.

4. Circuit arrangement according to Claim 1, **characterized in that**
the capacitance/frequency converter (Cf) has a respective negating AND gate having input hysteresis (IC2), the output signal (Out1, Out2, Out3) from which AND gate is supplied to the switch (SW1).

5. Circuit arrangement according to one of the preceding claims,
**characterized in that**
the evaluation circuit contains an event counter for counting the pulses in an output signal (Out1, Out2, Out3) from the sensor circuits.

6. Circuit arrangement according to one of the preceding claims,
**characterized in that**
the evaluation circuit compares the frequency of an output signal (Out1, Out2, Out3) from the sensor circuits with a respective basic frequency, the respective basic frequency being a frequency (which is averaged over a long period of time) of the output signal (Out1, Out2, Out3) from the respective sensor circuit when the respective capacitive sensor element (S) is not being touched.

## Revendications

1. Arrangement de circuit pour plusieurs détecteurs de contact capacitifs, comprenant plusieurs circuits de détection muni chacun d'un élément de détection capacitif (S) dont la valeur de la capacité (Ct) change en cas de contact ; et
un circuit d'interprétation auquel les signaux de sortie (Out1, Out2, Out3) des plusieurs circuits de détection sont acheminés en alternance par le biais d'un commutateur (SW1) afin de déterminer si les éléments de détection capacitifs (S) sont actionnés ou non,
chacun des plusieurs circuits de détection présentant un circuit parallèle constitué d'un condensateur (C1) et de l'élément de détection capacitif (S) et
un convertisseur capacité/fréquence (Cf) étant à chaque fois relié avec le circuit parallèle, lequel produit à sa sortie un signal de fréquence dont la fréquence dépend de la capacité totale du circuit parallèle correspondant constitué du condensateur (C1) et de l'élément de détection capacitif (S), **caractérisé en ce que**
chacun des plusieurs circuits de détection présente un oscillateur à signaux rectangulaires déconnectable qui est constitué du convertisseur capacité/fréquence (Cf) et du condensateur (C1) et un seul des plusieurs oscillateurs à signaux rectangulaires est activé à la fois.

2. Arrangement de circuit selon la revendication 1, **caractérisé en ce que** l'entrée du convertisseur capacité/fréquence (Cf) est à chaque fois branchée en parallèle avec le circuit parallèle constitué du condensateur (C1) et de l'élément de détection capacitif (S).

3. Arrangement de circuit selon la revendication 1 ou 2, **caractérisé en ce que** le convertisseur capacité/fréquence (Cf) est à chaque fois formé par une porte ET inverseuse (IC2) dont l'entrée qui est reliée au circuit parallèle constitué du condensateur (C1) et de l'élément de détection capacitif (S) présente une hystérésis.

4. Arrangement de circuit selon la revendication 1, **caractérisé en ce que** le convertisseur capacité/fréquence (Cf) présente à chaque fois une porte ET inverseuse avec hystérésis d'entrée (IC2) dont le signal de sortie (Out1, Out2, Out3) est acheminé au commutateur (SW1).

5. Arrangement de circuit selon l'une des revendications précédentes, **caractérisé en ce que** le circuit d'interprétation contient un compteur d'événements pour compter les impulsions d'un signal de sortie (Out1, Out2, Out3) des circuits de détection.

6. Arrangement de circuit selon l'une des revendications précédentes, **caractérisé en ce que** le circuit d'interprétation compare la fréquence d'un signal de sortie (Out1, Out2, Out3) des circuits de détection avec une fréquence de base correspondante, la fréquence de base correspondante étant une fréquence moyenne calculée sur une longue période du signal de sortie (Out1, Out2, Out3) du circuit de détection correspondant en l'absence de contact avec l'élément de détection capacitif (S) correspondant.
